(19) **Europäisches Patentamt**

**European Patent Office**

**Office européen des brevets**

(11) **EP 0 812 067 B1**

(12) **FASCICULE DE BREVET EUROPEEN**

(45) Date de publication et mention
de la délivrance du brevet:
**22.10.2003 Bulletin 2003/43**

(51) Int Cl.⁷: **H03K 17/78**, H01L 31/08

(21) Numéro de dépôt: **97401138.9**

(22) Date de dépôt: **23.05.1997**

(54) **Commutateur électrique à photoconducteur**

Photoleitfähiger elektrischer Schalter

Photoconductive electric switch

(84) Etats contractants désignés:
**CH DE GB LI**

(30) Priorité: **07.06.1996 FR 9607079**

(43) Date de publication de la demande:
**10.12.1997 Bulletin 1997/50**

(73) Titulaire: **Thales**
**75008 Paris (FR)**

(72) Inventeurs:
- **Pocholle, Jean-Paul, Thomson-CSF S.C.P.I.**
  **94117 Arcueil cedex (FR)**
- **Kaplan, Daniel, Thomson-CSF S.C.P.I.**
  **94117 Arcueil cedex (FR)**
- **De Saxce, Thibaut, Thomson-CSF S.C.P.I.**
  **94117 Arcueil cedex (FR)**
- **Lacassie, Franck, Thomson-CSF S.C.P.I.**
  **94117 Arcueil cedex (FR)**

(56) Documents cités:
GB-A- 1 466 676        GB-A- 2 131 227
US-A- 3 801 825        US-A- 5 332 918

- **CHIA-CHI WANG ET AL: "SUBPICOSECOND ELECTRICAL PULSE GENERATION BY EDGE ILLUMINATION OF SILICON AND INDIUM PHOSPHIDE PHOTOCONDUCTIVE SWITCHES" APPLIED PHYSICS LETTERS, vol. 67, no. 1, 3 juillet 1995, pages 79-81, XP000519033**

**Description**

L'invention concerne un commutateur électrique à photoconducteur.

La commutation électrique à photoconducteur consiste à relier deux éléments de circuit par un matériau semiconducteur, fortement isolant dans l'obscurité, et à établir la connexion en soumettant ce solide à un flux lumineux qui le rend conducteur. La conduction résulte ainsi de la photo-création de porteurs chargés électriquement (électrons et trous).

La commutation électrique à photoconducteur présente un certain nombre d'avantages comparativement aux autres modes de commande (mécanique, arcs électriques et décharge dans les gaz, ...).

- isolement galvanique de l'actuateur,
- temps de réponse intrinsèque très court, image de l'impulsion laser employée,
- absence de fluctuations dans l'instant d'établissement du courant qui est déterminé par l'apparition de la lumière.

La source optique de commande est représentée par un laser. Aujourd'hui, on réalise des impulsions ultracourtes optiques (quelques $10^{-15}$s) à partir de telles sources, ce qui permet d'obtenir des impulsions électriques à transitions très abruptes.

Dans le cas d'impulsions électriques de grande puissance (par exemple à l'échelle du MW), le photoconducteur est soumis à des courants élevés (kA). Il est alors souhaitable de disposer d'un photoconducteur de grande section (par exemple quelques mm$^2$). Par ailleurs, la commutation de fortes tensions (kV) implique l'emploi de structures de commutation de longueur suffisante (quelques mm) afin d'éviter d'atteindre le champ de rupture du matériau. Toutes les dimensions sont alors de l'ordre (ou supérieures) au mm et l'on souhaite créer des porteurs de charge dans l'ensemble du volume.

L'absorption optique des matériaux semiconducteurs à une longueur d'onde donnée est en général soit très faible (énergie du photon inférieure à celle de l'énergie de bande interdite du matériau), soit très élevée (coefficient d'absorption) de plusieurs centaines de cm$^{-1}$ dès que l'énergie du photon est plus grande que celle associée à la bande interdite). La recherche de valeurs intermédiaires du coefficient d'absorption exige un accord relativement précis entre la longueur d'onde d'excitation (laser) et la longueur d'onde seuil du semiconducteur (associée à l'énergie de bande interdite) ; accord qui n'est en général pas réalisé.

Par ailleurs, l'absorption étant très élevée, elle se fait de manière générale en surface du matériau. L'épaisseur de matériau ionisé est alors très faible. La section du matériau perpendiculaire à la direction de commutation et donc à la circulation d'un courant à commuter est très faible. S'il s'agit de commuter un courant à très forte intensité, le matériau risque d'être détérioré dans la zone d'absorption en raison de l'échauffement dû au passage du courant.

Certains semiconducteurs tel que le silicium présentent des coefficients d'absorption plus faibles aux longueurs d'ondes inférieures au seuil d'absorption (comparativement à GaAs). Ils présentent une limitation à la commutation de forte puissance. Par ailleurs, les caractéristiques des porteurs dans ces semiconducteurs sont peu favorables à l'obtention d'une commutation efficace (faible mobilité des porteurs).

L'invention a donc pour objet un commutateur électrique à photoconducteur permettant une commutation de courants élevés.

Elle concerne un commutateur électrique à photoconducteur comprenant un élément en matériau photoconducteur possédant deux électrodes situées de part et d'autre d'une zone active, au moins une source lumineuse émettant au moins un faisceau lumineux éclairant la zone active, le faisceau ayant une longueur d'onde correspondant à une énergie photonique inférieure à l'énergie de bande interdite du matériau photoconducteur, l'intensité du faisceau lumineux étant telle qu'il y ait combinaison de l'énergie d'au moins deux photons dans le matériau photoconducteur.

Les différents objets et caractéristiques de l'invention apparaîtront plus clairement dans la description qui va suivre et dans les figures annexées qui représentent :

- la figure 1, un exemple de réalisation simplifiée du dispositif de l'invention ;
- les figures 2a, 2b, des schémas d'explication du fonctionnement du dispositif de l'invention ;
- les figures 3, 4, 5, des courbes de fonctionnement du dispositif de l'invention ;
- la figure 6, un exemple de réalisation plus détaillé d'un commutateur selon l'invention.

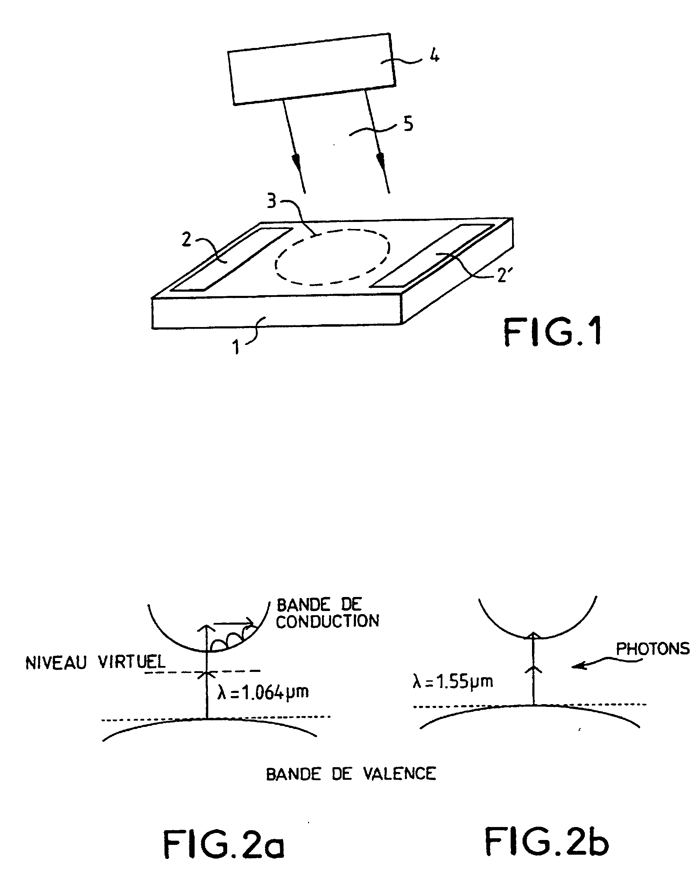

En se reportant à la figure 1, on va tout d'abord décrire un exemple de réalisation simplifiée du commutateur selon l'invention.

Un élément en matériau photoconducteur 1 possède, à deux extrémités opposées, deux électrodes 2, 2'. Entre ces deux électrodes, une zone 3 est éclairée par un faisceau 5 émis par une source 4. A titre d'exemple, la longueur d'onde du faisceau 5 est telle que son énergie photonique est inférieure ou égale à l'énergie de largeur de bande interdite du matériau photoconducteur 1. De plus, l'intensité optique du faisceau est telle qu'elle donne lieu à un phénomène d'absorption à deux photons ou bien, exprimé autrement, de telle façon que la somme des énergies de deux photons corresponde à l'énergie de bande interdite du matériau photoconducteur.

La distance effective sur laquelle sont générés les porteurs est de type millimétrique, ce qui permet de réaliser un plasma volumique plutôt que surfacique. Selon l'invention, le phénomène d'absorption à deux photons (A2P) est employé dans cette perspective.

Le mécanisme d'absorption à deux photons traduit l'excitation d'un matériau semiconducteur dans le domaine de transparence de celui-ci. L'effet de la longueur d'onde est schématisé sur les figures 2a et 2b.

Ce phénomène non-linéaire apparaît pour une forte densité d'excitation lumineuse. Son fonctionnement repose sur l'existence d'un niveau virtuel de durée de vie courte. Ce mécanisme est d'autant plus efficace que l'intensité optique de commande est appliquée au matériau semiconducteur en régime impulsionnel court.

On considère le matériau GaAs qui présente une énergie de bande interdite située au voisinage de 1,424 eV. Un photon issu d'un laser Nd:YAG (ou autre matrice) présente une énergie de 1,165 eV et l'absorption à deux photons correspond à 2,33 eV (figure 2a).

L'emploi d'une source opérant vers 1,55 $\mu$m (énergie du photon = 0,8 eV) permet d'atteindre 1,6 eV selon le processus non-linéaire d'absorption (figure 2b). Cette source peut être représentée par un laser verre dopé $Er^{3+}$ ou par une fibre laser (avec amplificateur fibré).

En négligeant l'absorption par les porteurs, l'évolution de l'intensité optique dans le milieu suit la loi :

$$\frac{dI(r,z,t)}{dz} = -\alpha \; I(r,z,t) - \beta \; I(r,z,t)^2$$

où $\alpha$ représente le coefficient d'absorption linéaire en intensité et $\beta$ est le coefficient d'absorption à deux photons. Cette équation a pour solution :

$$I(z) = \frac{I_o \; \alpha e^{-\alpha Z}}{\alpha + \beta \; I_o(1-e^{-\alpha Z})}$$

$I_o$ est l'intensité optique couplée au matériau semiconducteur

$$I_o = \frac{E_o}{\pi^{3-2} \; \tau_L w_0^2}$$

$E_o$ : est l'énergie contenue dans l'impulsion laser, $\tau_L$, $W_o$ représentent respectivement la largeur de l'impulsion et la dimension du rayon du faisceau laser à 1/e (cas d'une distribution gaussienne).

A titre d'exemple, on considère le matériau semiconducteur GaAs massif non dopé à haute pureté. Le coefficient d'absorption à la longueur d'onde $\lambda$ = 1,06 $\mu$m est typiquement compris entre $\alpha$ = 0,6 $cm^{-1}$ et 1,2 $cm^{-1}$. Le coefficient d'absorption à deux photons obtenu expérimentalement $\beta_{exp}$ est de l'ordre de 20 cm/GW.

Ce mode de fonctionnement ainsi décrit peut être réalisé à partir de matériaux et alliages semiconducteurs variés permettant de mettre en oeuvre cette architecture sur un large domaine spectral. Le volume excité est défini par :

• la section effective du faisceau laser,
• l'inverse du coefficient d'absorption ($cm^{-1}$).

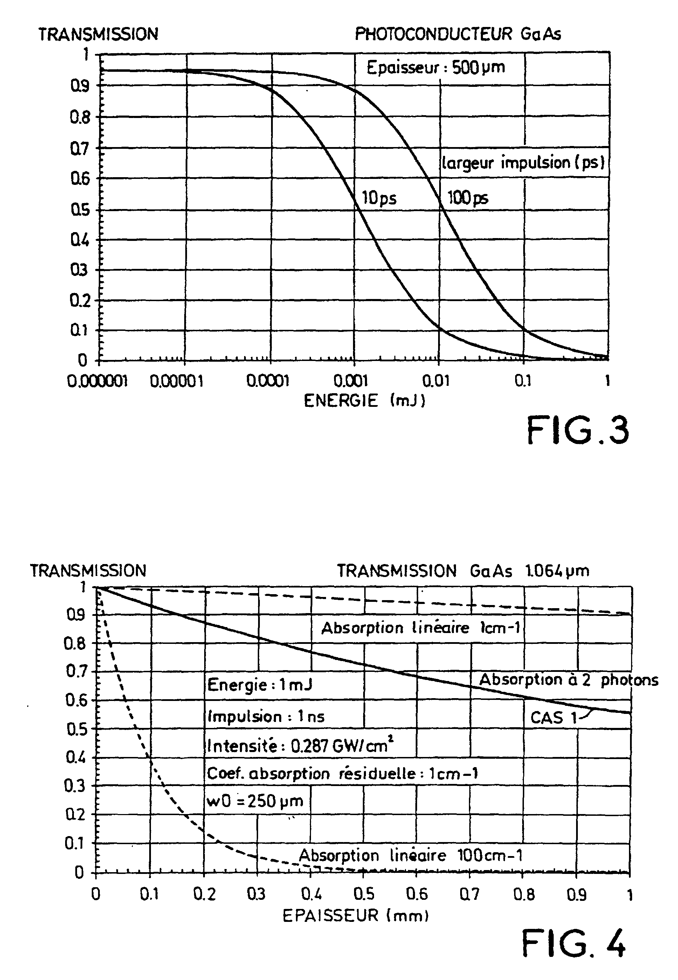

On considère la transmission lumineuse d'une plaquette d'arséniure de gallium d'épaisseur 500 $\mu$m. En tenant compte de l'absorption à deux photons, on calcule l'évolution de la transmission en fonction de l'énergie contenue dans l'impulsion lumineuse de commande. A la longueur d'onde 1,064 $\mu$m, en fonction de la largeur de l'impulsion on obtient les courbes de transmission présentées sur la figure 3. Le rayon de focalisation est de 50 $\mu$m et le coefficient de perte linéaire résiduel est de $1cm^{-1}$. On observe que 90 % de l'énergie est absorbée selon le processus d'absorption à deux photons pour une énergie laser de 10 $\mu$J contenue dans une impulsion de durée 10 ps interagissant avec le composé semiconducteur. Cette efficacité montre que le mécanisme d'absorption à deux photons peut être exploité pour engendrer au sein du photoconducteur des paires électrons-trous qui contribuent à réaliser un plasma de conduction en volume. Par contre, pour atteindre le taux d'absorption de 90 % avec une impulsion de durée de 100 ps, il faut une énergie de 100 $\mu$J.

Une autre représentation de l'effet consiste à évaluer la transmission en fonction de la profondeur de pénétration de l'onde optique dans le matériau photoconducteur (AsGa par exemple). Pour cela, on a considéré différents cas d'excitation.

Cas 1 : Source Laser Nd:YAG

• Energie par impulsion couplée au matériau semiconducteur : 1mJ
• Durée impulsion : 1ns
• Dimension focalisation : 250 $\mu$m

ce qui correspond à une intensité de : 0,287 GW/$cm^2$ (fluence = 0,287 J/$cm^2$)

Cas 2 : Source Laser Nd:YAG subnanoseconde

• Energie par impulsion couplée au semiconducteur : 10 $\mu$J
• Durée impulsion : 100 ps
• Dimension focalisation : 100 $\mu$m Intensité : 0,179 GW/$cm^2$ (fluence = 17,95 mJ/$cm^2$)

Cas 3 : Source Laser Nd:YAG picoseconde

• Energie par impulsion couplée au semiconducteur : 10 $\mu$J
• Durée impulsion : 10 ps
• Dimension focalisation : 100 $\mu$m Intensité : 1.796 GW/$cm^2$ (fluence = 17,95 mJ/$cm^2$)

Cas 4 : Source Laser Nd:YAG picoseconde

- Energie par impulsion couplée au semiconducteur : 10 µJ
- Durée impulsion : 10 ps
- Dimension focalisation : 250 µm Intensité : 0.287 GW/cm² (fluence = 2,87 mJ/cm²)

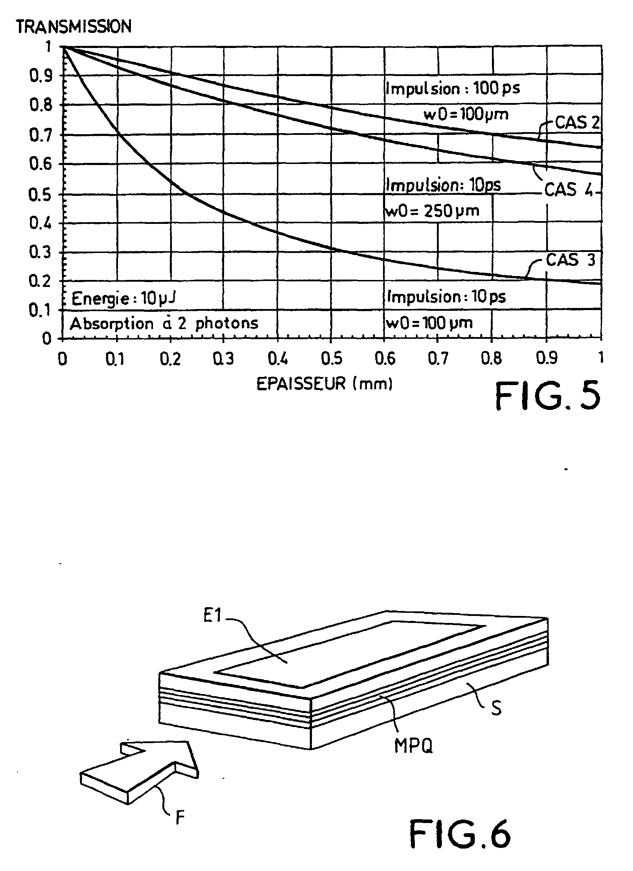

Les figures 4 et 5 permettent d'observer l'évolution de la transmission en fonction de la profondeur de pénétration de l'impulsion laser dans le matériau photoconducteur. La figure 4 correspond au cas 1. La figure 5 représente les cas 2, 3 et 4. L'absorption associée décrit la création de porteurs et par voie de conséquence l'ensemencement en volume de porteurs à partir d'un faisceau laser dont la longueur d'onde est située dans le domaine de transparence du matériau semiconducteur. Comme on peut le voir la transmission diminue et donc l'absorption à deux photons augmente lorsque l'énergie de l'impulsion lumineuse augmente (cas 1). Mais surtout, on remarque que pour une énergie lumineuse donnée (cas 1, 2 et 3) l'absorption est meilleure avec une impulsion de courte durée et une densité d'énergie par unité de surface plus grande (cas 3).

Les avantages du dispositif de l'invention sont :

- minimisation des effets thermiques en surface et en volume = = > réduction contraintes mécaniques, ce qui influe sur la tenue mécanique et la dégradation de l'interface,
- le volume excité est plus important ce qui entraîne une réduction des effets de filamentation, de l'effet Auger, un accroissement du courant pouvant être commuté, et une diminution du poids des effets d'interface (centres de recombinaison),
- il n'est pas nécessaire d'ajuster la longueur d'onde d'excitation optique à celle associée à la fenêtre d'absorption (bordure de bande) du semiconducteur,
- il est possible d'ajuster la distribution volumique des porteurs en jouant sur la focalisation au sein du matériau semiconducteur.

Les niveaux d'énergie (et les intensités) requis pour mettre en oeuvre au niveau des photoconducteurs ce mécanisme sont aujourd'hui accessibles à partir de sources miniatures délivrant des impulsions laser ultracourtes. Par ailleurs, il est possible d'ajuster le coefficient d'absorption en jouant sur la focalisation du faisceau optique ou la durée de l'impulsion laser.

La durée d'une impulsion sera comprise entre la sub-picoseconde et la sub-nanoseconde. Par exemple, elle sera comprise entre quelques fento-secondes ou dizaines de fento-secondes et quelques centaines de picosecondes.

A titre indicatif, l'emploi d'un laser opérant à 1,06 µm délivrant 10µJ dans une impulsion de 1 ps permet d'obtenir un coefficient d'absorption équivalent de 10 cm⁻¹ pour une tache d'éclairement de l'ordre de 1 mm². L'éclairement peut se faire soit directement dans l'espacement inter-électrodes, soit par la face arrière. La limitation dans ce cas est représentée par la largeur de l'impulsion qui occupe une distance de l'ordre de 100 µm pour une durée d'éclairement de 1 ps dans GaAs.

En revanche, au niveau du seuil de dommage optique, il s'avère que la fluence critique (J/cm²) varie selon une loi en $\Delta\tau^{1/2}$ pour des durées d'impulsion comprises entre la centaine de ps et au-delà, mais varie en $\Delta\tau^{-1}$ pour des impulsions ps ou subpicosecondes. La comparaison des cas 2 et 4 montre l'intérêt que l'on a de travailler avec des impulsions courtes en terme de fluence, pour un effet d'absorption à 2 photons.

Nous avons décrit ce mécanisme en considérant des structures conventionnelles d'éclateurs solides. Il est également permis d'envisager l'exploitation de cette interaction en considérant une configuration s'identifiant à un guide multimode transverse. Cette configuration est schématisée sur la figure 6. La ou les couches de matériau photoconducteur sont enserrées entre deux électrodes ou un substrat S et une électrode E1. Le faisceau F est incident sur le dispositif selon le plan de la ou des couches de matériau photoconducteur.

Les propriétés d'une telle structure sont représentées par :

- la possibilité d'emploi des techniques "Lift-off" autorisant un dépôt du matériau actif sur un substrat thermiquement adapté : silicium ou saphir (transparent à 1,06 µm),
- la commande dépend de la polarisation du faisceau excitateur (règle de sélection : couplage ondes électromagnétiques aux transitions électron-trou lourd/électron-trou léger),
- le confinement optique est propice à l'exploitation de l'absorption à deux photons,
- la longueur d'interaction peut être importante et l'emploi de structures évasées au niveau du guide permet de distribuer la densité de porteurs photoinduits,
- enfin, cette géométrie autorise l'empilement ("stacking") de multicommutateurs à commande optique unique.

**Revendications**

1. Commutateur électrique à photoconducteur comprenant un élément en matériau photoconducteur (1) possédant deux électrodes (2, 2') situées de part et d'autre d'une zone active (3), au moins une source lumineuse (4) émettant au moins un faisceau lumineux (5) éclairant la zone active (3), le faisceau (5) ayant une longueur d'onde correspondant à une énergie photonique inférieure à l'énergie de bande interdite du matériau photoconducteur (1), l'intensité du faisceau lumineux étant telle qu'il y ait combinaison de l'énergie d'au moins deux photons dans le matériau photoconducteur de façon qu'un mécanisme d'absorption à 2 photons dans le matériau photoconducteur contribue à la création de porteurs permettant de rendre conducteur le matériau photoconducteur.

2. Commutateur selon la revendication 1, **caractérisé en ce que** le faisceau a une longueur d'onde dont la valeur de l'énergie photonique est comprise entre la moitié de l'énergie de bande interdite du matériau photoconducteur et l'énergie de bande interdite du matériau.

3. Commutateur selon la revendication 1, **caractérisé en ce que** l'intensité du faisceau lumineux (5) a une valeur permettant une absorption photonique à deux photons dans le matériau photoconducteur.

4. Commutateur selon la revendication 3, **caractérisé en ce que** le faisceau lumineux (5) est transmis sous forme d'impulsions lumineuses dont la durée est de l'ordre de la sub-picoseconde à la sub-nanoseconde.

5. Commutateur selon la revendication 1, **caractérisé en ce que** la focalisation du faisceau lumineux sur le matériau photoconducteur est contrôlable.

6. Commutateur selon la revendication 1, **caractérisé en ce que** la source (4) est un laser dopé néodyme permettant une émission d'un faisceau lumineux à une longueur d'onde de 1,064 ou 1,32 μm.

7. Commutateur selon la revendication 1, **caractérisé en ce que** le matériau photoconducteur est du GaAs.

8. Commutateur selon la revendication 1, **caractérisé en ce que** l'élément en matériau photoconducteur (1) est de forme plane et **en ce que** la zone active éclairée par le faisceau lumineux est situé sur une face principale plane de l'élément.

9. Commutateur selon la revendication 8, **caractérisé en ce que** l'élément en matériau photoconducteur (1) est de forme plane et **en ce qu'**il est éclairé par l'une de ses tranches par le faisceau lumineux (5).

10. Commutateur selon la revendication 1, **caractérisé en ce que** le matériau photoconducteur est en As-Ga, la source laser est un laser YAG dopé néodyme.

11. Commutateur selon la revendication 1, **caractérisé en ce que** la durée de l'impulsion lumineuse est de l'ordre de 10 ps ou inférieure à 10 ps et que la fluence optique incidente est supérieure à 1,5 mJ/cm$^2$.

**Patentansprüche**

1. Elektrischer Schalter mit Photoleiter, der ein Element (1) aus Photoleitermaterial mit zwei Elektroden (2, 2') zu beiden Seiten einer aktiven Zone (3) und zumindest eine Lichtquelle (4) enthält, die mindestens einen die aktive Zone (3) beleuchtenden Lichtstrahl (5) aussendet, dessen Wellenlänge einer unter der Energie des verbotenen Bands des Photoleiterelements (1) liegenden Photonenenergie entspricht und dessen Intensität so gewählt ist, daß sich eine Energie-Kombination von mindestens zwei Photonen in dem Photoleiterelement ergibt derart, daß ein Absorptionsmechanismus mit zwei Photonen in dem Photoleiterelement zur Erzeugung von Ladungsträgern beiträgt, die das Photoleitermaterial leitend machen können.

2. Schalter nach Anspruch 1, **dadurch gekennzeichnet, daß** der Strahl eine Wellenlänge besitzt, deren Wert der Photonenenergie zwischen der Hälfte der Energie des verbotenen Bands des Photoleiterelements und der Energie dieses verbotenen Bands liegt.

3. Schalter nach Anspruch 1, **dadurch gekennzeichnet, daß** die Intensität des Lichtstrahls (5) einen Wert hat, bei dem eine Photonenabsorption mit zwei Photonen in dem Photoleiterelement möglich ist.

4. Schalter nach Anspruch 3, **dadurch gekennzeichnet, daß** der Lichtstrahl (5) in Form von Lichtimpulsen übertragen wird, deren Dauer im Bereich einer Sub-Pikosekunde bis zu einer Sub-Nanosekunde liegt.

5. Schalter nach Anspruch 1, **dadurch gekennzeichnet, daß** die Fokussierung des Lichtstrahls auf das Photoleiterelement einstellbar ist.

6. Schalter nach Anspruch 1, **dadurch gekennzeichnet, daß** die Lichtquelle (4) eine mit Neodym dotierte Laserquelle ist, die einen Lichtstrahl einer Wellenlänge von 1,064 oder 1,32 um aussenden kann.

7. Schalter nach Anspruch 1, **dadurch gekennzeichnet, daß** das Photoleiterelement aus GaAs ist.

8. Schalter nach Anspruch 1, **dadurch gekennzeichnet, daß** das Photoleiterelement (1) eine ebene Form besitzt und daß die vom Lichtstrahl beleuchtete aktive Zone auf einer ebenen Hauptseite des Elements liegt.

9. Schalter nach Anspruch 8, **dadurch gekennzeichnet, daß** das Photoleiterelement (1) eine flache Form besitzt und vom Lichtstrahl (5) über eine ihrer Schnittflächen beleuchtet wird.

10. Schalter nach Anspruch 1, **dadurch gekennzeichnet, daß** das Photoleitermaterial GaAs ist und die Laserquelle ein mit Neodym dotierter YAG-Laser ist.

11. Schalter nach Anspruch 1, **dadurch gekennzeichnet, daß** die Dauer des Lichtimpulses bei etwa 10 ps oder weniger liegt und daß die einfallende optische Fluenz größer als 1,5 mJ/cm$^2$ ist.

**Claims**

1. Photoconductive electrical switch comprising an element made of photoconductive material (1) possessing two electrodes (2, 2') that are located on either side of an active region (3), at least one light source (4) emitting at least one light beam (5) that illuminates the active region (3), the beam (5) having a wavelength corresponding to a photon energy less than the band gap energy of the photoconductive material (1), the intensity of the light beam being such that there is combining of the energy of at least two photons in the photoconductive material so that a two-photon absorption mechanism in the photoconductive material contributes to the creation of carriers that allow the photoconductive material to conduct.

2. Switch according to Claim 1, **characterized in that** the beam has a wavelength the value of the photon energy of which lies between one half of the band gap energy of the photoconductive material and the band gap energy of the material.

3. Switch according to Claim 1, **characterized in that** the intensity of the light beam (5) has a value allowing two-photon absorption in the photoconductive material.

4. Switch according to Claim 3, **characterized in that** the light beam (5) is transmitted in the form of light pulses of sub-picosecond to sub-nanosecond duration.

5. Switch according to Claim 1, **characterized in that** focusing of the light beam onto the photoconductive material can be controlled.

6. Switch according to Claim 1, **characterized in that** the source (4) is a neodymium-doped laser allowing the emission of a light beam with a wavelength of 1.064 or 1.32 μm.

7. Switch according to Claim 1, **characterized in that** the photoconductive material is GaAs.

8. Switch according to Claim 1, **characterized in that** the element made of photoconductive material (1) is of plane shape and **in that** the active region illuminated by the light beam lies on a plane principal face of the element.

9. Switch according to Claim 8, **characterized in that** the element made of photoconductive material (1) is a plane shape and **in that** it is illuminated via one of its edges by the light beam (5).

10. Switch according to Claim 1, **characterized in that** the photoconductive material is AsGa and the laser source is a neodymium-doped YAG laser.

11. Switch according to Claim 1, **characterized in that** the duration of the light pulse is of the order of 10 ps or less than 10 ps and **in that** the incident optical fluence is greater than 1.5 mJ/cm$^2$.

**FIG.1**

BANDE DE
CONDUCTION

NIVEAU VIRTUEL

$\lambda = 1.064 \mu m$

$\lambda = 1.55 \mu m$

PHOTONS

BANDE DE VALENCE

**FIG.2a**

**FIG.2b**

FIG.3

FIG. 4

TRANSMISSION

FIG. 5

FIG.6